# EUROPÄISCHE PATENTSCHRIFT

(11) **EP 1 102 168 B1**
(45) Veröffentlichungstag und Bekanntmachung des Hinweises auf die Patenterteilung: **06.07.2005**
(21) Anmeldenummer: 00124934.1
(22) Anmeldetag: 15.11.2000
(51) Int. Cl.: G11C 29/00

(54) **Integrierter Speicher mit Speicherzellen und Referenzzellen**
Integrated memory with memory cells and reference cells
Mémoire intégrée avec des cellules de mémoire et des cellules de référence

(30) Priorität: 22.11.1999 DE 19956069
(43) Veröffentlichungstag der Anmeldung: 23.05.2001
(73) Patentinhaber: Infineon Technologies AG, 81669 München (DE)
(72) Erfinder: Pöchmüller, Peter, 81739 München (DE)
(74) Vertreter: Ginzel, Christian

(56) Entgegenhaltungen:
- US-A- 5 844 832
- MASASHI HORIGUCHI ET AL: "A FLEXIBLE REDUNDANCY TECHNIQUE FOR HIGH-DENSITY DRAM'S" IEEE JOURNAL OF SOLID-STATE CIRCUITS, IEEE INC. NEW YORK, US, Bd. 26, Nr. 1, 1991, Seiten 12-17, XP000179338 ISSN: 0018-9200

## Beschreibung

Die Erfindung betrifft einen integrierten Speicher mit _{S}pₑi-cherzellen und Referenzzellen.

Ein derartiger integrierter Speicher in Form eines FRAMs (Ferroelectric Random Access Memory) ist in der US 5,844,832 A beschrieben. Die Referenzzellen dienen zur Erzeugung eines Referenzpotentials auf Bitleitungen des Speichers, bevor ein Zugriff auf eine der Speicherzellen erfolgt. Eine Auswahl der Speicherzellen erfolgt über mit ihnen verbundene Wortleitungen, während eine Auswahl der Referenzzellen über mit diesen verbundene Referenzwortleitungen erfolgt.

Allgemein bekannt ist es, bei integrierten Speichern zur Reparatur von Defekten redundante Speicherzellen vorzusehen, die mit redundanten Wortleitungen verbunden sind. Durch Programmierung einer entsprechenden Logik kann erreicht werden, daß während des Betriebs des Speichers die redundante Wortleitung mit den daran angeschlossenen redundanten Speicherzellen eine der normalen Wortleitungen mit den daran angeschlossenen Speicherzellen adressenmäßig ersetzt.

Der Erfindung liegt die Aufgabe zugrunde, einen integrierten Speicher anzugeben, der sowohl normale Speicherzellen als auch Referenzzellen aufweist und bei dem eine Reparatur von Defekten mittels redundanter Speicherzellen durchführbar ist, wobei für die redundanten Elemente möglichst wenig Platz aufgewendet werden soll.

Diese Aufgabe wird mit einem integrierten Speicher gemäß Anspruch 1 gelöst. Eine vorteilhafte Weiterbildung der Erfindung ist Gegenstand des abhängigen Anspruchs.

Beim erfindungsgemäßen integrierten Speicher sind redundante Speicherzellen vorhanden, die in Kreuzungspunkten einer redundanten Wortleitung und Bitleitungen des Speichers angeordnet sind. Weiterhin weist der Speicher eine programmierbare Aktivierungseinheit auf, von deren Programmierzustand abhängt, ob die redundante Wortleitung mit den daran angeschlossenen redundanten Speicherzelle während des Betriebs des Speichers eine der Wortleitungen mit den daran angeschlossenen Speicherzellen oder die Referenzwortleitung mit den daran angeschlossenen Referenzzellen ersetzt.

Während bei herkömmlicher Wortleitungsredundanz eine redundante Wortleitung lediglich zum adressenmäßigen Ersetzen einer der normalen Wortleitungen programmiert werden kann, besteht beim erfindungsgemäßen integrierten Speicher die Wahlmöglichkeit, ob die redundante Wortleitung zu diesem Zweck oder aber zum Ersetzen einer der Referenzwortleitungen eingesetzt werden soll. Somit sind dank der Erfindung mit einer redundanten Wortleitung und den daran angeschlossenen redundanten Speicherzellen sowohl Defekte von normalen Speicherzellen als auch Defekte von Referenzzellen beziehungsweise Defekte auf den mit diesen verbundenen normalen Wortleitungen beziehungsweise Referenzwortleitungen reparierbar. Dies bedeuten eine deutlich höhere Flexibilität beim Einsatz der Wortleitungsredundanz. Wollte man dagegen separate redundante Wortleitungen zum einen für die Reparatur von Defekten der normalen Wortleitungen und zum anderen zur Reparatur von Defekten einer der Referenzwortleitungen vorsehen, müßte der integrierte Speicher eine größere Anzahl von redundanten Wortleitungen aufweisen, als der erfindungsgemäße Speicher. Die Erfindung beruht nämlich auf der Erkenntnis, daß ein Speicher zwar eine große Anzahl von normalen Wortleitungen, jedoch nur eine äußerst geringe Anzahl, nämlich beispielsweise ein oder zwei, Referenzwortleitungen pro Speicherblock aufweist. Die Wahrscheinlichkeit, daß eine der Referenzwortleitungen einen Defekt aufweist, ist daher viel geringer, als daß ein Defekt einer der normalen Wortleitungen auftritt. Daher wäre das Vorsehen separater redundanter Wortleitungen zur Reparatur der normalen Wortleitungen einerseits und zur Reparatur der Referenzwortleitungen andererseits uneffektiv. Durch das Vorsehen einer gemeinsamen redundanten Wortleitung zur wahlweisen Reparatur von einer der normalen Wortleitungen oder einer der Referenzwortleitungen kann daher bei der Erfindung die Anzahl der redundanten Wortleitungen relativ gering gehalten werden, so daß deren Platzbedarf ebenfalls gering ist.

Nach einer Weiterbildung der Erfindung weist die Aktivierungseinheit des integrierten Speichers eine erste Teileinheit auf, die der Unterscheidung dient, ob die redundante Wortleitung während des Betriebs des Speichers eine der Wortleitungen oder die Referenzwortleitung ersetzt. Weiterhin weist die Aktivierungseinheit eine zweite Teileinheit auf, die den Zeitpunkt der Aktivierung der redundanten Wortleitung durch die Aktivierungseinheit bestimmt. Zu diesem Zweck aktiviert die zweite Teileinheit bei einem Zugriff auf eine der Speicherzellen im Falle des Ersetzens der Referenzwortleitung durch die redundante Wortleitung diese zur Erzeugung der Referenzpotentials, bevor eine Aktivierung einer der Wortleitungen erfolgt. Im Falle des Ersetzens einer der Wortleitungen durch die redundante Wortleitung aktiviert die zweite Teileinheit diese erst, nachdem eine Aktivierung der Referenzwortleitung zur Erzeugung des Referenzpotentials erfolgt ist.

Die Erfindung wird im folgenden anhand von in den Figuren dargestellten Ausführungsbeispielen des integrierten Speichers näher erläutert. Es zeigen:
- Figur 1: das Zellenfeld eines erfindungsgemäßen integrierten Speichers,
- Figur 2: eine Aktivierungseinheit des Speichers aus Figur 1 und
- Figur 3: Potentialverläufe zum Speicher aus Figur 1.

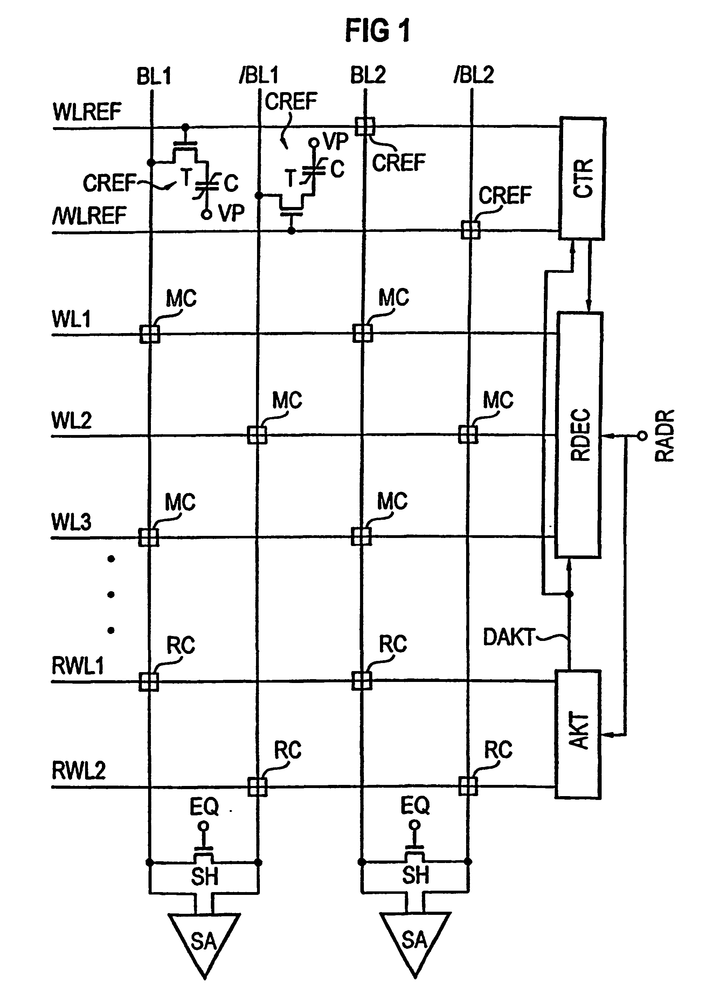

Figur 1 zeigt Speicherzellen MC des integrierten Speichers, die in Kreuzungspunkten von Bitleitungen BLi, /BLi mit Wortleitungen WLi angeordnet sind. Der Speicher weist eine Vielzahl der Wortleitungen WLi auf, von denen in Figur 1 jedoch nur drei dargestellt wurden. Außerdem weist der Speicher eine Vielzahl der Bitleitungen auf, von denen in der Figur 1 lediglich zwei Bitleitungspaare dargestellt wurden. Jedes Bitleitungspaar ist mit einem Leseverstärker SA verbunden, der zum Verstärken von auf dem Bitleitungspaar auftretenden Differenzsignalen dient. Die beiden Bitleitungen jedes Bitleitungspaares BL1, /BL1; BL2, /BL2 sind über einen Kurzschlußtransistor SH miteinander verbunden. Das Gate des Kurzschlußtransistors SH ist mit einem Kurzschlußsignal EQ verbunden.

Der Speicher in Figur 1 weist weiterhin Referenzzellen CREF auf, die in Kreuzungspunkten der Bitleitungen BLi, /BLi mit Referenzwortleitungen WLREF, /WLREF angeordnet sind. Die Referenzzellen CREF dienen zur Erzeugung eines Referenzpotentials auf den Bitleitungen, wie weiter unten noch erläutert wird. Der Speicher weist außerdem redundante Speicherzellen RC auf, die in Kreuzungspunkten der Bitleitungen BLi, /BLi mit redundanten Wortleitungen RWL1, RWL2 angeordnet sind.

Der Aufbau der Speicherzellen MC, der Referenzzellen CREF und der redundanten Speicherzellen RC ist jeweils identisch. In Figur 1 wurden lediglich zwei der Referenzzellen CREF explizit dargestellt, wohingegen die restlichen Referenzzellen CREF, die Speicherzellen MC und die redundanten Speicherzellen RC lediglich durch Quadrate an den jeweiligen Kreuzungspunkten im Speicherzellenfeld angedeutet wurden. Jede der Zellen weist einen Auswahltransistor T und einen Speicherkondensator C auf. Es handelt sich um Speicherkondensatoren C mit ferroelektrischem Dielektrikum. Der Speicher ist ein ferroelektrischer Speicher vom Typ FRAM. Die eine Elektrode des Speicherkondensators C ist über die steuerbare Strecke des Auswahltransistors T mit der zugehörigen Bitleitung BLi; /BLi verbunden. Die andere Elektrode des Speicherkondensators C ist mit einem Plattenpotential VP verbunden. Das Gate des Auswahltransistors T ist mit der zugehörigen Wortleitung WLi beziehungsweise Referenzwortleitung WLREF, /WLREF beziehungsweise redundanten Wortleitung RWL1, RWL2 verbunden.

Die Wortleitungen WLi sind mit Ausgängen eines Zeilendecoders RDEC verbunden. Die Referenzwortleitungen WLREF, /WLREF sind mit Ausgängen einer Steuerschaltung CTR verbunden. Die redundanten Wortleitungen RWL1, RWL2 sind mit Ausgängen einer Aktivierungseinheit AKT verbunden. Der Aktivierungseinheit AKT und dem Zeilendecoder RDEC werden eingangsseitig Zeilenadressen RADR zugeführt.

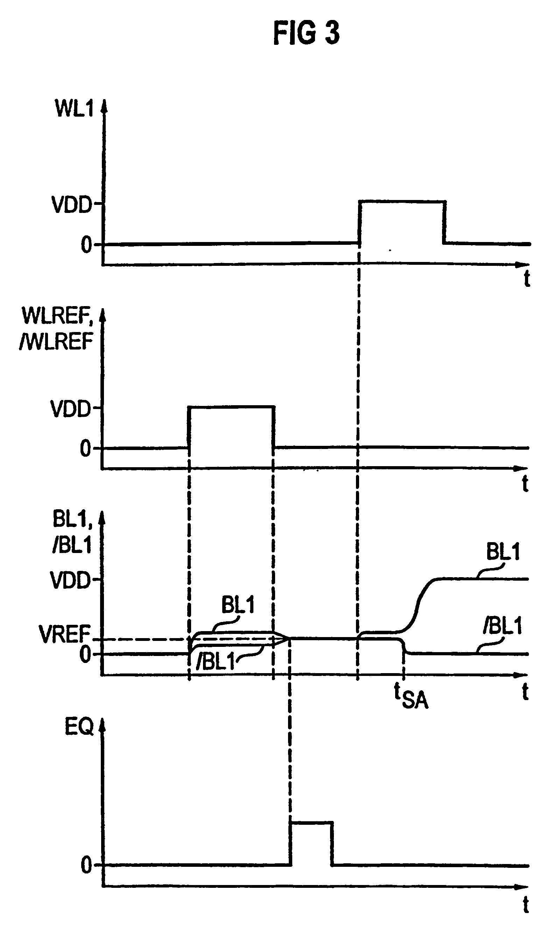

Im folgenden wird anhand Figur 3 die Funktionsweise der in Figur 1 gezeigten Schaltung für den Fall erläutert, daß kein Defekt einer der Speicherzellen MC oder Referenzzellen CREF aufgetreten ist, so daß eine Aktivierung einer der redundanten Wortleitungen RWL1, RWL2 durch die Aktivierungseinheit AKT unterbleibt. Es wird beispielhaft ein Zugriff auf diejenige Speicherzelle MC erläutert, die sich im Kreuzungspunkt der Wortleitung WL1 mit der Bitleitung BL1 befindet. Zunächst werden die beiden Bitleitungen BL1, /BL1 auf Masse entladen. Zuvor wurde bereits in der mit der Bitleitung BL1 verbundenen Referenzzelle CREF eine logische "1" und in der mit der Bitleitung /BL1 verbundenen Referenzzelle CREF eine logische "0" gespeichert. Sobald die beiden Referenzwortleitungen WLREF, /WLREF einen hohen Pegel annehmen, wird der Inhalt aus den beiden Referenzzellen CREF, die mit dem ersten Bitleitungspaar BL1, /BL1 verbunden sind, auf die beiden Bitleitungen ausgelesen. Nachdem die beiden Referenzwortleitungen wieder einen niedrigen Pegel angenommen haben, erfolgt ein Kurzschließen der beiden Bitleitungen BL1, /BL1 mittels eines hohen Pegels des Kurzschlußsignals EQ am Gate des Kurzschlußtransistors SH. Hierdurch stellt sich das gewünschte Referenzpotential VREF, das einem Mittelwert der zuvor auf den beiden Bitleitungen BL1, /BL1 befindlichen Potentiale entspricht, auf beiden Bitleitungen ein.

Nachdem der Kurzschlußtransistor SH wieder gesperrt worden ist, indem das Kurzschlußsignal EQ einen niedrigen Pegel annimmt, wird die erste Wortleitung WL1 in Abhängigkeit einer am Zeilendecoder RDEC anliegenden Zeilenadresse RADR auf einen hohen Pegel gebracht, wodurch unter anderem der Auswahltransistor T der auszulesenden Speicherzelle MC im Kreuzungspunkt mit der ersten Bitleitung BL1 leitend geschaltet wird. Bei der Darstellung in Figur 3 wurde angenommen, daß in dieser Speicherzelle MC eine logische "1" gespeichert ist. Hierdurch erhöht sich das Potential auf der ersten Bitleitung BL1 gegenüber dem Referenzpotential VREF, das zunächst noch auf der zweiten Bitleitung /BL1 beibehalten wird. Anschließend wird zu einem Zeitpunkt t_{SA} der Leseverstärker SA, der bis dahin deaktiviert war, aktiviert, so daß er das Differenzsignal auf dem Bitleitungspaar BL1, /BL1 auf volle Versorgungspegel VDD, Masse verstärkt.

Figur 3 ist zu entnehmen, daß bei jedem Lesezugriff auf eine der Speicherzellen MC zunächst die beiden Referenzwortleitungen WLREF, /WLREF aktiviert werden müssen, um das Referenzpotential VREF zu erzeugen, bevor die mit der Speicherzelle MC verbundene Wortleitung WLi aktiviert wird.

Die in Figur 1 eingezeichneten redundanten Wortleitungen RWL1, RWL2 mit den daran angeschlossenen redundanten Speicherzellen RC dienen im Redundanzfall jeweils zum wahlweisen Ersetzen einer der Wortleitungen WLi mit den daran angeschlossenen Speicherzellen MC oder dem Ersetzen einer der Referenzwortleitungen WLREF, /WLREF mit den daran angeschlossenen Referenzzellen CREF. Dabei kann die erste redundante Wortleitung RWL1 lediglich derartige Wortleitungen WL1, WL3 oder Referenzwortleitungen WLREF ersetzen, deren Speicherzellen in Kreuzungspunkten mit den Bitleitungen BL1, BL2 angeordnet sind. Die zweite redundante Wortleitung RWL2 dient dagegen zum Ersetzen defekter Wortleitungen WL2 bzw. defekter Referenzwortleitungen /WLREF, deren Speicherzellen in Kreuzungspunkten mit den Bitleitungen /BL1, /BL2 angeordnet sind.

Wird eine der Wortleitungen WLi durch eine der redundanten Wortleitungen RWL1, RWL2 "repariert", ersetzt letztere diese adressenmäßig. Das heißt, bei Anlegen der entsprechenden Zeilenadresse RADR wird die ersetzende redundante Wortleitung an Stelle der zu ersetzenden Wortleitung WLi aktiviert.

Wird eine der Referenzwortleitungen WLREF, /WLREF durch eine der redundanten Wortleitungen RWL1, RWL2 "repariert", wird letztere vor jeder Aktivierung einer der Wortleitungen WLi zur Erzeugung des Referenzpotentials VREF auf den Bitleitungen an Stelle der zu ersetzenden Referenzwortleitung aktiviert.

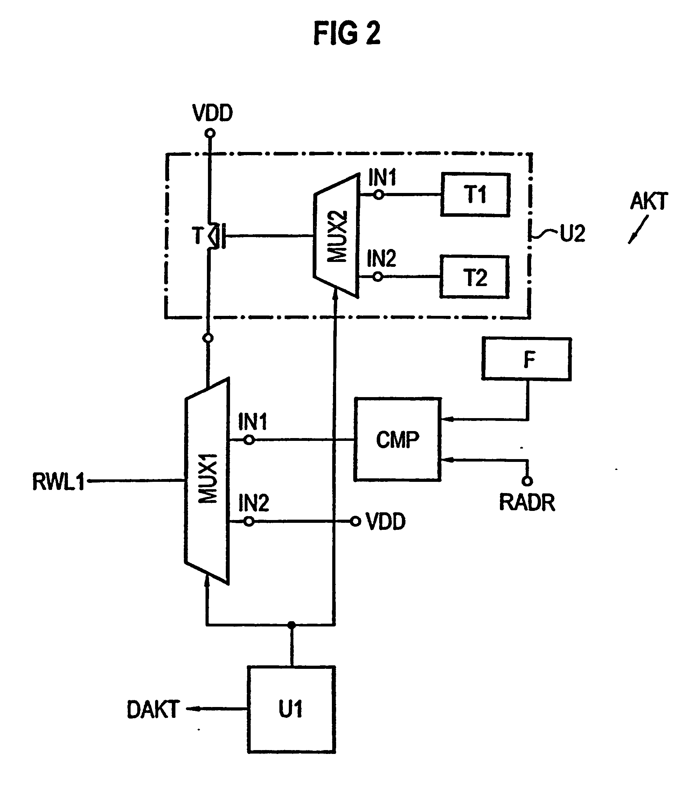

Erfolgt über die Aktivierungseinheit AKT die Aktivierung einer der redundanten Wortleitungen RWL1, RWL2 (worauf noch anhand Figur 2 eingegangen wird), steuert die Aktivierungseinheit AKT die Steuereinheit CTR beziehungsweise den Zeilendecoder RDEC über ein Steuersignal DAKT in einer Weise an, daß eine Aktivierung der zu ersetzenden Wortleitung WLi beziehungsweise Referenzwortleitung WLREF, /WLREF unterbleibt.

Je nachdem, ob durch die redundante Wortleitung eine der nor-malen Wortleitungen WLi oder eine der Referenzwortleitungen WLREF, /WLREF ersetzt wird, erfolgt eine Aktivierung der redundanten Wortleitung über die Aktivierungseinheit AKT mit dem der Figur 3 entnehmbaren Zeitverhalten. Hierdurch ist sichergestellt, daß die redundante Wortleitung im Falle des Ersetzens einer der Wortleitungen WLi erst nach Aktivierung der Referenzwortleitungen WLREF, /WLREF und der damit verbundenen Erzeugung des Referenzpotentials VREF aktiviert wird und daß die redundante Wortleitung im Falle des Ersetzens einer der Referenzwortleitungen WLREF, /WLREF bereits vor der Aktivierung einer der Wortleitungen WLi aktiviert wird, so daß mit ihrer Hilfe das Referenzpotential VREF auf den Bitleitungen erzeugt wird.

Figur 2 zeigt den Aufbau der Aktivierungseinheit AKT aus Figur 1. Die Aktivierungseinheit AKT weist je redundanter Wortleitung RWL1, RWL2 die in Figur 2 gezeigten Komponenten auf. Dargestellt wurden nur die der ersten redundanten Wortleitung RWL1 zugeordneten Komponenten. Die Aktivierungseinheit AKT weist einen ersten Multiplexer MUX1, einen zweiten Multiplexer MUX2, eine erste Teileinheit U1 sowie eine zweite Teileinheit U2 auf. Die erste Teileinheit U1 ist programmierbar, so daß festgelegt werden kann, ob die redundante Wortleitung RWL1 dem Ersetzen einer der Wortleitungen WLi oder einer der Referenzwortleitungen WLREF, /WLREF dient. Die erste Teileinheit U1 steuert den Schaltzustand der Multiplexer MUX1, MUX2. Ersetzt die redundante Wortleitung RWL1 eine der normalen Wortleitungen WLi, sind Signale an ersten Eingängen IN1 der beiden Multiplexer MUX1, MUX2 maßgeblich für deren Ausgangssignale. Ersetzt dagegen die redundante Wortleitung RWL1 eine der Referenzwortleitungen WLREF, /WLREF, sind Signale an zweiten Eingängen IN2 der beiden Multiplexer MUX1, MUX2 maßgeblich für die Ausgangssignale der Multiplexer.

Der erste Eingang IN1 des ersten Multiplexers MUX1 ist mit dem Ausgang eines Komparators CMP verbunden. Dessen einer Eingang ist mit programmierbaren Elementen F in Form von elektrischen Fuses verbunden, die zum Einstellen einer Adresse einer zu ersetzenden Wortleitung WLi dienen. Einem zweiten Eingang des Komparators CMP werden Zeilenadressen RADR zugeführt. Stellt der Komparator CMP eine Übereinstimmung seiner beiden Eingangssignale fest, nimmt sein Ausgang einen hohen Pegel an. Der erste Multiplexer MUX1 führt dann eine Aktivierung der redundanten Wortleitung RWL1 durch, sobald er mit einem Versorgungspotential VDD über einen Transistor T verbunden wird. Der Zeitpunkt des Leitendschaltens des Transistors T wird durch das Ausgangssignal des zweiten Multiplexers MUX2 bestimmt. Beim Ersetzen einer der Wortleitungen WLi durch die redundante Wortleitung RWL1 ist das Ausgangssignal einer ersten Zeiteinheit T1, die mit dem ersten Eingang IN1 des zweiten Multiplexers MUX2 verbunden ist, maßgeblich. Die erste Zeiteinheit T1 bewirkt ein Leitendschalten des Transistors T und damit eine Aktivierung des ersten Multiplexers MUX1 durch das Verbinden mit dem Versorgungspotential VDD erst, nachdem das Referenzpotential VREF gemäß Figur 3 mittels der Referenzwortleitungen WLREF, /WLREF erzeugt worden ist.

Der zweite Eingang IN2 des ersten Multiplexers MUX1 ist mit dem Versorgungspotential VDD verbunden. Der zweite Eingang IN2 des zweiten Multiplexers MUX2 ist mit einer zweiten Zeiteinheit T2 verbunden, die über den Transistor T eine Aktivierung des ersten Multiplexers MUX1 mit dem in Figur 3 gezeigten Zeitverhalten der Referenzwortleitungen WLREF, /WLREF bewirkt. Ersetzt die redundante Wortleitung RWL1 eine der Referenzwortleitung WLREF, /WLREF, erfolgt aufgrund des Versorgungspotentials VDD am zweiten Eingang IN2 des ersten Multiplexers MUX1 eine Aktivierung der redundanten Wortleitung RWL1, sobald der Transistor T in Abhängigkeit von der zweiten Zeiteinheit T2 leitend geschaltet worden ist.

Die erste Teileinheit U1 in Figur 2 dient außerdem zum Erzeugen des Steuersignals DAKT, in dessen Abhängigkeit der Zeilendecoder RDEC bzw. die Steuereinheit CTR aus Figur 1 in der Weise gesteuert werden, daß eine Aktivierung der jeweils durch die redundante Wortleitung RWL1 zu ersetzenden Wortleitung WLi bzw. Referenzwortleitung WLREF unterbleibt.

## Patentansprüche

1. Integrierter Speicher
- mit Speicherzellen (MC), die in Kreuzungspunkten von Wortleitungen (WLi) und Bitleitungen (BLi, /BLi) angeordnet sind,
- mit Referenzzellen (CREF), die in Kreuzungspunkten von wenigstens einer Referenzwortleitung (WLREF, /WLREF) und den Bitleitungen (BLi, /BLi) angeordnet sind und die zur Erzeugung eines Referenzpotentials (VREF) auf den Bitleitungen vor einem Zugriff auf eine der Speicherzellen (MC) dienen,
- mit redundanten Speicherzellen (RC), die in Kreuzungspunkten einer redundanten Wortleitung (RWL1, RWL2) und den Bitleitungen (BLi, /BLi) angeordnet sind, **gekennzeichnet durch**
- eine programmierbare Aktivierungseinheit (AKT), von deren Programmierzustand abhängt, ob die redundante Wortleitung (RWL1, RWL2) mit den daran angeschlossenen redundanten Speicherzellen (RC) während des Betriebs des Speichers eine der Wortleitungen (WLi) mit den daran angeschlossenen Speicherzellen (MC) oder die Referenzwortleitung (WLREF, /WLREF) mit den daran angeschlossenen Referenzzellen (CREF) ersetzt.

2. Integrierter Speicher nach Anspruch 1,
- dessen Aktivierungseinheit (AKT) eine erste Teileinheit (U1) und eine zweite Teileinheit (U2) aufweist,
- dessen erste Teileinheit (U1) der Unterscheidung dient, ob die redundante Wortleitung (RWL1, RWL2) während des Betriebs des Speichers eine der Wortleitungen (WLi) oder die Referenzwortleitung (WLREF, /WLREF) ersetzt,
- und dessen zweite Teileinheit (U2) den Zeitpunkt der Aktivierung der redundanten Wortleitung (RWL1, RWL2) durch die Aktivierungseinheit bestimmt, indem sie bei einem Zugriff auf eine der Speicherzellen (MC)
- im Falle des Ersetzens der Referenzwortleitung (WLREF, /WLREF) durch die redundante Wortleitung (RWL1, RWL2) diese zur Erzeugung des Referenzpotentials (VREF) aktiviert, bevor eine Aktivierung einer der Wortleitungen (WLi) erfolgt,
- und im Falle des Ersetzens einer der Wortleitungen (WLi) durch die redundante Wortleitung (RWL1, RWL2) diese erst aktiviert, nachdem eine Aktivierung der Referenzwortleitung (WLREF, /WLREF) zur Erzeugung des Referenzpotentials (VREF) erfolgt ist.

## Claims

1. Integrated memory
- having memory cells (MC) arranged at points of intersection between word lines (WLi) and bit lines (BLi, /BLi),
- having reference cells (CREF) which are arranged at points of intersection between at least one reference word line (WLREF, /WLREF) and the bit lines (BLi, /BLi) and which are used to generate a reference potential (VREF) on the bit lines before an access operation to one of the memory cells (MC),
- having redundant memory cells (RC) arranged at points of intersection between a redundant word line (RWL1, RWL2) and the bit lines (BLi, /BLi), **characterized by**
- a programmable activation unit (AKT) whose programming state governs whether the redundant word line (RWL1, RWL2) having the redundant memory cells (RC) connected thereto replaces one of the word lines (WLi) having the memory cells (MC) connected thereto or the reference word line (WLREF, /WLREF) having the reference cells (CREF) connected thereto during operation of the memory.

2. Integrated memory according to Claim 1,
- whose activation unit (AKT) has a first subunit (U1) and a second subunit (U2),
- whose first subunit (U1) is used to distinguish whether the redundant word line (RWL1, RWL2) replaces one of the word lines (WLi) or the reference word line (WLREF, /WLREF) during operation of the memory,
- and whose second subunit (U2) determines the instant at which the redundant word line (RWL1, RWL2) is activated by the activation unit by virtue of the fact that, during an access operation to one of the memory cells (MC),
- when the reference word line (WLREF, /WLREF) is being replaced by the redundant word line (RWL1, RWL2), the second subunit (U2) activates the latter, for the purpose of generating the reference potential (VREF), before one of the word lines (WLi) is activated,
- and, when one of the word lines (WLi) is being replaced by the redundant word line (RWL1, RWL2), the second subunit (U2) does not activate the latter until after the reference word line (WLREF, /WLREF) has been activated for the purpose of generating the reference potential (VREF).

## Revendications

1. Mémoire intégrée,
- comprenant des cellules (MC) de mémoire qui sont disposées aux points d'intersection de lignes (WLi) de mots et de lignes (BLi, /BLi) de bits ;
- comprenant des cellules (CREF) de référence qui sont disposées aux points d'intersection d'une ligne (WLREF, NVLREF) de mots de référence et des lignes (BLi, /BLi) de bits et qui servent à produire un potentiel (VREF) de référence sur les lignes de bit avant un accès à l'une des cellules (MC) de mémoire ;
- comprenant des cellules (RC) de mémoire redondante qui sont disposées aux points d'intersection d'une ligne (RWL1, RWL2) de mots redondante et des lignes (BLi, /BLi) de bits, **caractérisée par**
- une unité (AKT) programmable d'activation, dont l'état de programmation dépend du point de savoir si la ligne (RWL1, RWL2) de mots redondante, avec les cellules (RC) de mémoire redondantes qui y sont raccordées, remplace pendant le fonctionnement de la mémoire l'une des lignes (WLi) de mots, avec les cellules (MC) de mémoire qui y sont raccordées, ou la ligne (WLREF, /WLREF) de mots de référence, avec les cellules (CREF) de référence qui y sont raccordées.

2. Mémoire intégrée suivant la revendication 1,
- dont l'unité (AKT) d'activation comprend une première sous-unité (U1) et une deuxième sous-unité (U2),
- dont la première sous-unité (U1) sert à distinguer si la ligne (RWL1, RWL2) de mots redondante remplace, pendant le fonctionnement de la mémoire, l'une des lignes (WLi) de mots ou la ligne (WLREF, /WLREF) de mots de référence ;
- et dont la deuxième sous-unité (U2) détermine l'instant de l'activation de la ligne (RWL1, RWL2) de mots redondante par le fait qu'elle active lors d'un accès à l'une des cellules (MC) de mémoire ;
- dans le cas du remplacement de la ligne (WLREF, /WLREF) de mots de référence par la ligne (RWL1, RWL2) de mots redondante, celle-ci pour la production du potentiel (VREF) de référence avant que s'effectue une activation de l'une des lignes (WLi) de mots ,
- et dans le cas du remplacement de l'une des lignes (WLi) de mots par la ligne (RWL1, RWL2) de mots redondante, celle-ci seulement après qu'une activation de la ligne (WLREF, /WLREF) de mots de référence a eu lieu pour la production du potentiel (VREF) de référence.
